# EUROPÄISCHE PATENTSCHRIFT

(11) **EP 0 453 644 B1**
(45) Veröffentlichungstag und Bekanntmachung des Hinweises auf die Patenterteilung: **10.05.1995**
(21) Anmeldenummer: 90123355.1
(22) Anmeldetag: 05.12.1990
(51) Int. Cl.: H01L 21/768, H01L 21/60, H01L 27/108

(54) **Verfahren zur Herstellung einer Öffnung in einem Halbleiterschichtaufbau und dessen Verwendung zur Herstellung von Kontaktlöchern**
Method of making a hole in a semiconductor layer structure and its use in manufacturing contact holes
Procédé pour la fabrication d'un trou dans une structure semi-conductrice en couches et son utilisation pour la fabrication des trous de contact

(30) Priorität: 27.04.1990 DE 4013629
(43) Veröffentlichungstag der Anmeldung: 30.10.1991
(73) Patentinhaber: SIEMENS AKTIENGESELLSCHAFT, 80333 München (DE)
(72) Erfinder: Rösner, Wolfgang, Dr., W-8014 Neubiberg (DE)

(56) Entgegenhaltungen:
- EP-A- 0 439 965
- PATENT ABSTRACTS OF JAPAN vol. 11, no. 288 (E-542)(2735) 17. September 1987 & JP-A-62 086 853
- PATENT ABSTRACTS OF JAPAN vol. 13, no. 416 (E-821)(3764) 14. September 1989 & JP-A-11 55 656

## Beschreibung

### Verfahren zur Herstellung einer Öffnung in einem Halbleiterschichtaufbau und dessen Verwendung zur Herstellung von Kontaktlöchern

Die Erfindung betrifft ein Verfahren zur Herstellung einer Öffnung in einem Halbleiterschichtaufbau sowie die Verwendung des Verfahrens zur Herstellung von Kontaktlöchern.

Es ist allgemein bekannt, zur Herstellung von Öffnungen mit Hilfe von Ätzprozessen in einem Halbleiterschichtaufbau eine Photomaske zu verwenden. Eine Photomaske wird hergestellt aus einer Photolackschicht, die durch eine Projektionsmaske belichtet wurde. Dabei muß die Projektionsmaske zu dem Halbleiterschichtaufbau justiert werden. Wegen der unvermeidlichen Justiertoleranzen muß dabei ein Sicherheitsabstand zwischen dem für die Öffnung vorgesehenen Ort und im Halbleiterschichtaufbau benachbarten Komponenten eingehalten werden. Eine Öffnung, die beispielsweise als Kontaktloch für einen Bildleitungskontakt in einem DRAM verwendet wird, muß in einem Sicherheitsabstand entsprechend der gegebenen Kantenlagegenauigkeit von der Wortleitung plaziert werden.

Bei der Herstellung von Öffnungen, die als Kontaktlöcher verwendet werden, tritt insbesondere das Problem auf, daß die Öffnung in einer Passivierungsschicht erzeugt wird, die auch benachbarte Komponenten bedeckt und zur Isolierung zwischen den benachbarten Komponenten und einem in dem Kontaktloch erzeugten Kontakt dient. Es besteht daher bei der Herstellung der Öffnung die Gefahr, daß Teile benachbarter Komponenten freigeätzt werden, was nach Fertigstellung des Kontaktes zu Kurzschlüssen führt.

Um eine höhere Integrationsdichte in Halbleiterschaltungen erzielen zu können, muß der Sicherheitsabstand zwischen den benachbarten Komponenten der Öffnung reduziert werden.

Aus K.H. Küsters et al, Journal de Physique, coll. C4, Suppl. au n°=9, Tome 49, C4-503 bis C4-506 ist ein selbstjustiertes Herstellverfahren für ein Kontaktloch in einem 4 Mbit - DRAM bekannt. Durch Verwendung selbstjustierender Herstellverfahren werden Sicherheitsabstände zur Berücksichtigung von Justiertoleranzen eingespart. In dem bekannten Verfahren wird vor Abscheidung einer planarisierenden Bor-Phosphor-Silikat-Glas-Schicht eine oder mehrere Hilfsschichten als Ätzstopp aufgebracht, um ein Freiätzen der Wortleitung zu verhindern. Das Kontaktloch wird dann in die Bor-Phosphor-Silikat-Glas-Schicht geätzt. Wird dabei das Bor-Phosphor-Silikat-Glas naßgeätzt, ergibt sich eine sehr große laterale Ätzung. Bei Trockenätzung des Bor-Phosphor-Silikat-Glases entsteht durch die begrenzte Ätzselektivität des Bor-Phosphor-Silikat-Glas gegenüber dem Ätzstopp eine Dünnung der Isolation zur Wortleitung. Es muß daher bei der Ätzzeit ein Kompromiß eingegangen werden zwischen einer sauberen Öffnung des Kontaktloches und der verbleibenden Isolationsdicke auf der Wortleitung.

Der Erfindung liegt die Aufgabe zugrunde, ein weiteres Herstellverfahren anzugeben zur Herstellung einer Öffnung in einem Halbleiterschichtaufbau, das auch für solche Öffnungen geeignet ist, die benachbarte Strukturen überlappen. Das verfahren soll insbesondere geeignet sein zur Herstellung von Kontaktlöchern.

Die Aufgabe wird durch ein Verfahren gemäß Anspruch 1 mit folgenden Schritten gelöst:
a) auf einer Struktur wird an einem für die Öffnung vorgesehenen Ort ein Platzhalter aus einem ersten Material erzeugt, das selektiv zur darunterliegenden Struktur und zu Material das der fertigen Öffnung benachbart ist, ätzbar ist,
b) auf der Struktur mit dem Platzhalter wird ganzflächig eine Schicht aus einem zweiten Material, zu dem das erste Material selektiv ätzbar ist, erzeugt,
c) die Öffnung wird dadurch erzeugt, daß oberhalb des Platzhalters die Schicht aus dem zweiten Material mindestens teilweise entfernt wird und der Platzhalter durch selektives Ätzen entfernt wird.

An dem Ort, an dem die Öffnung in einer Schicht vorgesehen ist, wird vor dem Abscheiden der Schicht ein Platzhalter erzeugt. Dabei wird das Material für den Platzhalter so gewählt. daß es selektiv zu die fertige Öffnung umgebendem Material ätzbar ist. Durch diese, für die Erfindung wesentliche Maßnahme wird sichergestellt, daß das Material des Platzhalters vollständig aus der Öffnung entfernt wird. Da andererseits das erste Material, aus dem der Platzhalter besteht, selektiv zu der darunterliegenden Struktur ätzbar ist, werden bei der Erzeugung des Platzhalters durch einen Ätzvorgang weder die darunterliegende Struktur noch dem Platzhalter bzw. der Öffnung benachbarte Komponenten durch Ätzabtrag beeinträchtigt.

Sollte die Oberfläche der Struktur die Bedingung der Selektivität beim Ätzen des ersten Materials nicht in genügendem Ausmaß erfüllen, liegt es im Rahmen der Erfindung mindestens an dem für die Öffnung vorgesehenen Ort eine Hilfsschicht zu erzeugen, zu der das erste Material selektiv ätzbar ist.

Das Verfahren ist zur Herstellung beliebiger Öffnungen in einem Halbleiterschichtaufbau geeignet. Die Auswahl des ersten Materials für den Platzhalter erfolgt mit Rücksicht auf die Auswahl des zweiten Materials für die Schicht so, daß das erste Material mit möglichst guter Selektivität zu dem zweiten Material ätzbar ist. Beispielsweise wird für das erste Material Polysilizium und als zweites Material SiO₂ oder als erstes Material SiO₂ und als zweites Material Silizium verwendet.

Das Verfahren ist insbesondere zur Herstellung von Kontaktlöchern in Passivierungsschichten geeignet. Bei Passivierungsschichten aus einem SiO₂-haltigen Material, z. B. Bor-Phosphor-Silikat-Glas, wird als erstes Material für den Platzhalter Polysilizium verwendet. Da diese Materialien standardmäßig in der Halbleitertechnologie verwendet werden, hat dieses Verfahren den Vorteil, daß sein Einsatz keine wesentliche Beschränkung für den Gesamtprozeß durch Ätzselektivitäten erfordert.

Da der Platzhalter mit guter Selektivität zur darunterliegenden Struktur ätzbar ist, sind Form und Lage des Platzhalters beliebig. Insbesondere kann der Platzhalter benachbarte Komponenten teilweise überlappen. Mit dem erfindungsgemäßen Verfahren wird gegenüber justierten Verfahren zur Herstellung von Öffnungen, insbesondere Kontaktlöchern, daher eine Platzersparnis erzielt.

Weitere Ausgestaltungen der Erfindung gehen aus den übrigen Ansprüchen hervor.

Im folgenden wird die Erfindung anhand eines Ausführungsbeispiels und der Figuren näher erläutert.
- Fig. 1: zeigt die Herstellung des Platzhalters.
- Fig. 2 und Fig. 3: zeigen den mit der Schicht aus zweitem Material bedeckten Platzhalter.
- Fig. 4: zeigt die fertige Öffnung in der Schicht aus dem zweiten Material.

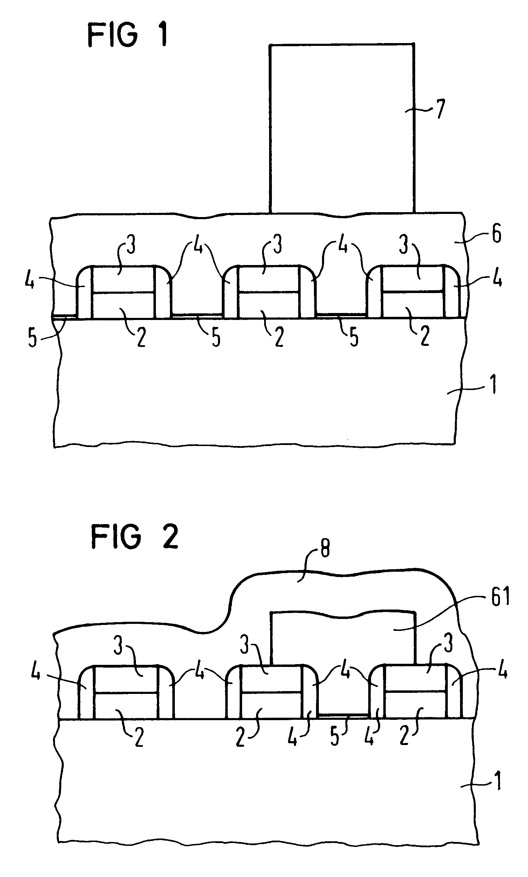

In dem Ausführungsbeispiel wird von einer Struktur ausgegangen, die ein Substrat 1 enthalt. Das Substrat 1 besteht aus Silizium und weist z. B. Source-Bereiche, Drain-Bereiche, Kanalimplantationen und aktive Elemente trennende Isolationsstrukturen auf. Auf dem Substrat 1 sind Leiterbahnen 2 angeordnet. Die Leiterbahnen 2 sind im allgemeinen von dem Substrat 1 durch eine Isolationsschicht, z. B. ein Gateoxid, getrennt, die der Übersichtlichkeit halber nicht dargestellt ist. Die Leiterbahnen 2 bestehen aus elektrisch leitfähigem Material, z. B. aus dotiertem Polysilizium. Die Leiterbahnen 2 stellen z. B. Wortleitungen in einem DRAM dar. Auf den Leiterbahnen 2 sind an der dem Substrat 1 abgewandten Oberfläche SiO₂-Strukturen 3 angeordnet. Die SiO₂-Strukturen 3 und die Leiterbahnen 2 werden aus einer entsprechenden Doppelschicht in ein und demselben Strukturierungsschritt hergestellt. Die Flanken der SiO₂-Strukturen 3 und der Leiterbahnen 2 sind mit Flankenbedeckungen (sog. Spacer) 4 versehen. Die Flankenbedeckungen 4 bestehen z. B. aus SiO₂. Sie werden durch ganzflächiges, konformes Abscheiden einer SiO₂-Schicht, z. B. durch thermisches Zersetzen von Si(OC₂H₅)₄ (sog. TEOS), in einer Dicke von z. B. 200 nm und anschließendes anisotropes Rückätzen dieser Schicht hergestellt. Bei dem Rückätzen wird die Oberfläche des Substrats 1 zwischen benachbarten Flankenbedeckungen 4 außerhalb der Leiterbahnen 2 freigeätzt. Die freiliegende Oberfläche des Substrats 1 wird mit einer Oxidschicht 5 versehen. Die Oxidschicht 5 wird z. B. durch thermische Oxidation bei 900°C mit 3 % HCl oder durch thermische Zersetzung von TEOS in einer Dicke von 20 nm hergestellt (s. Fig. 1).

Die Struktur bestehend aus dem Substrat 1, den Leiterbahnen 2, den SiO₂-Strukturen 3, den Flankenbedeckungen 4 und der Oxidschicht 5 weist an ihrer Oberfläche durchgehend SiO₂ auf. Auf diese Struktur wird ganzflächig eine Schicht 6 aus z. B. Polysilizium erzeugt. Die Schicht 6 weist eine Dicke von z. B. 700 nm auf. Die Schicht 6 kann dotiert oder undotiert abgeschieden werden. Polysilizium hat die Eigenschaft mit guter Selektivität von etwa 30:1 in dem anisotropen Ätzprozeß mit Cl₂/He zu SiO₂ ätzbar zu sein.

Auf der Schicht 6 wird eine Photolackstruktur 7 erzeugt. Die Photolackstruktur 7 bedeckt den Bereich der Schicht 6, in dem eine Öffnung erzeugt werden soll.

In einem anisotropen Ätzprozeß wird die Schicht 6 außerhalb der Photolackstruktur 7 zurückgeätzt. Als Ätzprozeß ist z. B. die Trockenätzung mit Cl₂/He geeignet. Außerhalb der Photolackstruktur 7 wird die Oberfläche der SiO₂-Strukturen, der Flankenbedeckungen 4 und der Oxidschicht 5 freigelegt. Um ein vollständiges Entfernen der Schicht 6 aus Polysilizium auch in den von den Flankenbedeckungen 4 und der Oxidschicht 5 gebildeten Ecken sicherzustellen, muß ein 100%iges Überätzen vorgenommen werden. Da der verwendete Ätzprozeß eine Selektivität von Polysilizium zu SiO₂ von 30:1 aufweist, ist dieses Überätzen möglich, ohne daß eine Beschädigung von früher freigelegten SiO₂-Strukturen befürchtet werden muß. In diesem Strukturierungsschritt entsteht aus der Schicht 6 aus Polysilizium ein Platzhalter 61 (s. Fig. 2).

Oxidschichten 5, die nicht von dem Platzhalter 61 bedeckt sind, können in einem zur Substratoberfläche selektiven Ätzprozeß entfernt werden. Auf die sich ergebende Oberfläche wird ganzflächig eine Passivierungsschicht 8 aus z. B. Bor-Phosphor-Silikat-Glas aufgebracht. Die Passivierungsschicht 8 wird in einer Dicke von z. B. 700 nm durch thermisches Zersetzen von TEOS mit einer Dotierung von 4,3 Gewichtsprozent Bor und 4,3 Gewichtsprozent Phosphor erzeugt.

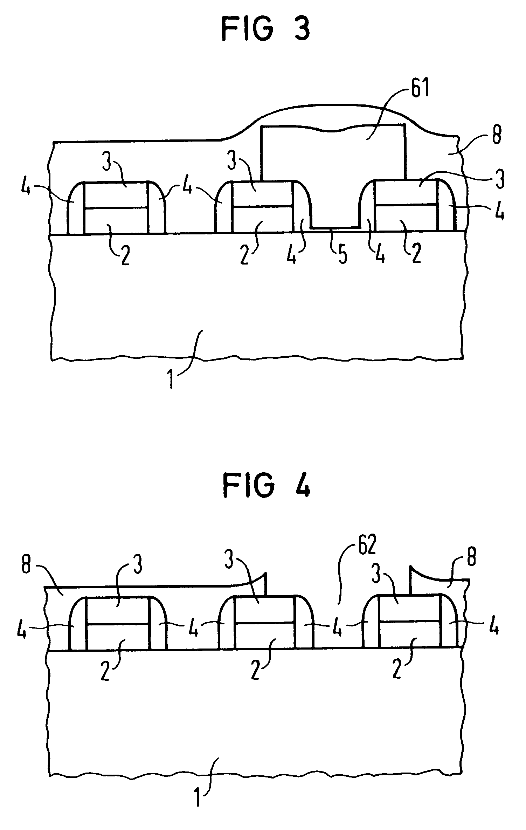

In einem Verfließprozeß bei einer Temperatur von z. B. 900 °C während z. B. 40 Minuten wird die Passivierungsschicht 8 planarisiert (s. Fig. 3). Dabei nimmt die Dicke der Passivierungsschicht 8 oberhalb des Platzhalters 61 ab, während sie in den Bereichen außerhalb des Platzhalters 61 zum Teil zunimmt.

Nach einem technologisch notwendigen Freiätzen der Rückseite der Halbleiterscheibe, wobei die Vorderseite mit Photolack geschützt ist (nicht dargestellt) wird nach dem Entfernen des schützenden Photolacks die Passivierungsschicht 8 um z. B. etwa 500 nm zurückgeätzt. Dabei werden mindestens die Ecken des Platzhalters 61 freigelegt. Durch naßchemisches Ätzen wird der Platzhalter 61 aus Polysilizium herausgeätzt. Dabei entsteht an der Stelle des Platzhalters 61 eine Öffnung 62 (s. Fig. 4). Die naßchemische Ätzung erfolgt z. B. mit Cholin (4%). Sie ist äußerst selektiv zu SiO₂-haltigem Material. In einem anisotropen Ätzschritt wird die Oxidschicht 5 (s. Fig. 3) im Bereich der Öffnung 62 entfernt (s. Fig. 4).

Die Öffnung 62 kann im folgendem in bekannter Weise z. B. mit einer Metallisierung für einen Bitleitungskontakt versehen werden (nicht dargestellt).

Die in dem erfindungsgemäßen Verfahren notwendigen Ätzschritte erfolgen jeweils selektiv zur vorhandenen Unterlage. Daher können die Ätzzeiten für eine optimale Strukturierung in dem jeweiligen Schritt eingestellt werden. Falls die auf dem Platzhalter 61 nach dem Verfließprozeß verbleibende Schicht des Bor-Phosphor-Silikat-Glas recht dick ist, kann durch eine Vergrößerung der Dicke der Passivierungsschicht 8 sowie der SiO₂-Strukturen 3 dennoch ein Freiätzen der Leiterbahnen 2 verhindert werden. Die Verwendung einer dickeren Passivierungsschicht 8 hat den vorteil, daß die sich in der Nachbarschaft der Öffnung 62 ergebenden Spitzen der Passivierungsschicht 8 abgeflacht werden.

Die in dem Ausführungsbeispiel verwendeten Materialien Polysilizium, Siliziumoxid und Bor-Phosphor-Silikat-Glas sowie die verwendeten Ätzverfahren sind in der Halbleitertechnologie standardmäßig verbreitet. Das erfindungsgemäße Herstellverfahren ist daher ohne Aufwand in bestehende Herstellprozesse zu integrieren.

## Patentansprüche

1. Verfahren zur Herstellung einer Öffnung in einem Halbleiterschichtaufbau mit folgenden Schritten:
a) auf einer Struktur (1, 2, 3, 4, 5) wird an einem für die Öffnung (62) vorgesehenen Ort ein Platzhalter (61) aus Polysilizium erzeugt, das selektiv zur darunterliegenden Struktur (1, 2, 3, 4, 5) und zu Material (3, 4, 8), das der fertigen Öffnung (62) benachbart ist, ätzbar ist,
b) auf der Struktur (1, 2, 3, 4, 5) mit dem Platzhalter (61) wird ganzflächig eine planarisierende Schicht (8) aus einem SiO₂-haltigen Material erzeugt,
c) die Öffnung (62) wird dadurch erzeugt, daß oberhalb des Platzhalters (61) die Schicht (8) aus dem SiO₂-haltigen Material mindestens teilweise entfernt wird und der Platzhalter (61) durch selektives Ätzen entfernt wird.

2. Verfahren nach Anspruch 1,
**dadurch gekennzeichnet,**
daß das Entfernen der Schicht (8) aus dem SiO₂-haltigen Material oberhalb des Platzhalters (61) durch ganzflächiges Rückätzen der Schicht (8) aus dem SiO₂-haltigen Material erfolgt.

3. Verfahren nach Anspruch 1 oder 2,
**dadurch gekennzeichnet,**
daß auf der Struktur (1, 2, 3, 4) vor der Erzeugung des Platzhalters (61) mindestens an dem für die Öffnung (62) vorgesehe nen Ort eine Hilfsschicht (5) erzeugt wird, zu der Polysilizium selektiv ätzbar ist.

4. Verfahren nach Anspruch 3,
**dadurch gekennzeichnet,**
daß nach dem Entfernen des Platzhalters (61) im Bereich der Öffnung (62) die Hilfsschicht (5) durch anisotropes Ätzen entfernt wird.

5. Verfahren nach einem der Ansprüche 1 bis 4,
**dadurch gekennzeichnet,** daß die Struktur (1, 2, 3, 4, 5) in ihrer Oberfläche Erhebungen aufweist und daß der Platzhalter (61) zwischen benachbarten Er hebungen so erzeugt wird, daß er die Erhebungen jeweils seitlich überlappt.

6. Verfahren nach Anspruch 5,
**gekennzeichnet durch**
folgende Schritte:
a) auf der in ihrer Oberfläche Erhebungen aufweisenden Struktur (1, 2, 3, 4, 5) wird eine Schicht (6) aus Polysilizium erzeugt,
b) auf der Schicht (6) aus Polysilizium wird an dem für die Öffnung (62) vorgesehenen Ort eine Photolackstruktur (7) erzeugt,
c) der von der Photolackstruktur unbedeckte Teil der Schicht (6) aus dem Polysilizium wird vollständig entfernt, wodurch der Platzhalter (61) entsteht.
d) nach dem Entfernen der Photolackstruktur (7) wird die Schicht (8) aus dem SiO₂-haltigen Material erzeugt.

7. Verwendung eines Verfahrens nach einem der Ansprüche 1 bis 6 zur Herstellung von Kontaktlöchern für überlappende Kontakte in einer integrierten Schaltung.

8. Verwendung eines Verfahrens nach einem der Ansprüche 1 bis 6 zur Erzeugung von Kontaktlöchern für Bitleitungskontakte in DRAM.

## Claims

1. Method for producing an opening in a semiconductor layer structure, comprising the following steps:
a) there is generated, on a pattern (1, 2, 3, 4, 5), at a position designated for the opening (62), a dummy (61) composed of polysilicon, which can be etched selectively with respect to the pattern (1, 2, 3, 4, 5) situated beneath it and to material (3, 4, 8) which is adjacent to the finished opening (62),
b) there is generated on the pattern (1, 2, 3, 4, 5) together with the dummy (61), over the entire surface, a planarizing layer (8) composed of an SiO₂-containing material,
c) the opening (62) is generated by the layer (8) composed of the SiO2-containing material being removed, at least in part, above the dummy (61) and the dummy (61) being removed by selective etching.

2. Method according to Claim 1, characterized in that the removal of the layer (8) composed of the SiO₂-containing material above the dummy (61) being effected by all-over etch-back of the layer (8) composed of the SiO₂-containing material.

3. Method according to Claim 1 or 2, characterized in that there is generated on the pattern (1, 2, 3, 4), prior to generating the dummy (61), at least at the location designated for the opening (62), an auxiliary layer (5) with respect to which polysilicon is selectively etchable.

4. Method according to Claim 3, characterized in that after removal of the dummy (61), in the region of the opening (62), the auxiliary layer (5) is removed by anisotropic etching.

5. Method according to any one of Claims 1 to 4, characterized in that the pattern (1, 2, 3, 4, 5) has projections in its surface, and in that the dummy (61) between adjacent projections is generated in such a way that it laterally overlaps each of the projections.

6. Method according to Claim 5, characterized by the following steps:
a) there is generated, on the pattern (1, 2, 3, 4, 5) having projections in its surface, a layer (6) composed of polysilicon,
b) there is generated, on the layer (6) composed of polysilicon, at the location designated for the opening (62), a photoresist pattern (7),
c) that part of the layer (6) composed of the polysilicon, which is not covered by the photoresist pattern, is completely removed, thus producing the dummy (61),
d) after removal of the photoresist pattern (7), the layer (8) composed of the SiO₂-containing material is generated.

7. The use of a method according to any one of Claims 1 to 6 for producing contact holes for overlapping contacts in an integrated circuit.

8. The use of a method according to any one of Claims 1 to 6 for generating contact holes for bit line contacts in a DRAM.

## Revendications

1. Procédé pour ménager une ouverture dans une structure formée de couches semiconductrices, comprenant les étapes suivantes :
a) sur une structure (1,2,3,4,5), on forme, en un emplacement prévu pour l'ouverture (62), une entretoise (61) en polysilicium, que l'on peut corroder de façon sélective jusqu'à la structure sous-jacente (1,2,3,4,5) et jusqu'au matériau (3,4,8), qui est voisin de l'ouverture terminée (62),
b) sur toute la surface de la structure (1,2,3,4,5) pourvue d'entretoises (61), on forme une couche de planarisation (8) formée d'un matériau contenant du SiO₂,
c) on crée l'ouverture (62) en éliminant au moins partiellement, au-dessus de l'entretoise (61), la couche (8) formée du matériau contenant du SiO₂ et on élimine l'entretoise (61) par corrosion sélective.

2. Procédé suivant la revendication 1, caractérisé par le fait que l'élimination de la couche (8) formée du matériau contenant du SiO₂ au-dessus de l'entretoise (61) s'effectue au moyen d'une rétrocorrosion de toute la surface de la couche (8) formée du matériau contenant du SiO₂.

3. Procédé suivant la revendication 1 ou 2, caractérisé par le fait que sur la structure (1,3,4) on forme, avant la réalisation d'entretoises (61) et au moins à l'emplacement prévu pour l'ouverture (62), une couche auxiliaire (5), jusqu'à laquelle on peut corroder de façon sélective le polysilicium.

4. Procédé suivant la revendication 3, caractérisé par le fait qu'après l'élimination de l'entretoise (61), on élimine par corrosion anisotrope la couche auxiliaire (5) dans la zone de l'ouverture (62).

5. Procédé suivant l'une des revendications 1 à 4, caractérisé par le fait que la structure (1,2,3,4,5) possède des bossages au niveau de sa surface et qu'on forme l'entretoise (61) entre des bossages voisins de manière qu'elle chevauche latéralement les bossages.

6. Procédé suivant la revendication 5, caractérisé par les étapes suivantes :
a) sur la structure (1,2,3,4,5), qui possède des bossages dans sa surface, on forme une couche (6) en polysilicium,
b) sur la couche (6) en polysilicium, on forme une structure de photolaque (7) à l'emplacement prévu pour l'ouverture (62),
c) on élimine complètement la partie, qui n'est pas recouverte par la structure de photolaque, de la couche (6) en polysilicium, ce qui fait apparaître l'entretoise (61),
d) après élimination de la structure de photolaque (7), on forme la couche (8) formée du matériau contenant du SiO₂.

7. Utilisation d'un procédé suivant l'une des revendications 1 à 6 pour fabriquer des trous de contact pour des contacts en chevauchement dans un circuit intégré.

8. Utilisation d'un procédé suivant l'une des revendications 1 à 6 pour la production de trous de contact dans des contacts de lignes de transmission de bits dans une mémoire DRAM.
